# EUROPÄISCHE PATENTSCHRIFT

(11) **EP 2 211 599 B1**
(45) Veröffentlichungstag und Bekanntmachung des Hinweises auf die Patenterteilung: **04.01.2012**
(21) Anmeldenummer: 09151112.1
(22) Anmeldetag: 22.01.2009
(51) Int. Cl.: H05K 7/14

(54) **Baugruppe und Baugruppenträger**
Assembly and assembly holder
Composant et support de composant

(43) Veröffentlichungstag der Anmeldung: 28.07.2010
(73) Patentinhaber: Siemens Aktiengesellschaft, 80333 München (DE)
(72) Erfinder: Deinhardt, Günther, 92224 Amberg (DE)

(56) Entgegenhaltungen:
- EP-A- 1 524 889
- FR-A- 2 432 258
- US-A1- 2004 047 128
- US-A1- 2004 201 972

## Beschreibung

Die Erfindung betrifft eine Baugruppe zum Einschwenken in einen Baugruppenträger, umfassend ein kastenförmiges Gehäuse an dem ein erstes Haltemittel zur Verbindung mit einem ersten Befestigungsmittel des Baugruppenträgers angeordnet ist, wobei durch diese Verbindung das Gehäuse schwenkbar ist.

Des Weiteren betrifft die Erfindung einen Baugruppenträger zum Aufnehmen der Baugruppe.

Auf dem Gebiet der Automatisierungstechnik ist es bekannt, Baugruppen in Baugruppeträgern einzustecken und somit ein modulares System aufzubauen. Die Baugruppen müssen dabei in dem Baugruppenträger sicher verankert werden und gegen ein Herausfallen gesichert werden. Weiterhin kann es wichtig sein, insbesondere bei sicherheitstechnischen Produktions- oder Fertigungsanlagen, einen Wechsel einer elektrischen Baugruppe während des Betriebes der Anlage so zu gestalten, dass keine kritischen Zustände auftreten. Hierbei ist eine Forderung in einigen Bereichen der Fertigungsanlagen, dass die Anlage bzw. Teile der Anlage für den Wechsel der elektrischen Baugruppe nicht spannungslos geschaltet werden müssen. Ist die elektrische Baugruppe aber beispielsweise über einen Stromkreis derart mit dem Baugruppenträger verbunden, dass beim Stecken oder Ziehen der Baugruppe eine Funkenbildung am Stecker zwischen der elektrischen Baugruppe und dem Baugruppenträger nicht ausgeschlossen werden kann, sind besondere konstruktive Maßnahmen vorzusehen, die diese Funkenbildung sicher verhindern.

Aus der Patentschrift DE 103 30 260 B4 ist eine Baugruppe zum Einstecken in einen Baugruppenträger bekannt. Nachteilig an dieser Vorrichtung ist es, dass die Baugruppe einen auf dem Baugruppenträger befindlichen Bussteckverbinder nicht sicher zugeführt werden kann und die Baugruppe nicht sicher verriegelt werden kann, wie es für industrielle Bedingungen, beispielsweise Vibrations- und Schockbelastungen notwendig ist.

Aus der EP 0 419 694 B1 ist eine Baugruppe zum Einschwenken in einen Baugruppenträger bekannt, nachteilig an dieser Baugruppe ist es, dass diese über zwei Schraubbolzen befestigt werden muss.

Aus der FR 2 432 258 A ist ein Profilschienenbefestigungs-System für elektronische Baugruppen bekannt.

Es ist daher die Aufgabe der Erfindung eine Baugruppe bereitzustellen, welches ein einfaches, aber sicheres Verriegeln und Entriegeln der Baugruppe ermöglicht.

Die Erfindung wird durch die Merkmale des Anspruchs 1 gelöst. Ausgehend von einer kastenähnlichen vorzugweise rechteckförmigen Baugruppe weist die Baugruppe eine erste bis sechste Seite, entsprechend ihrer Seitenflächen auf. Um eine derartige Baugruppe in einen Baugruppenträger einzuschwenken, wird sie üblicherweise über ein erstes Haltemittel, welches an einer ersten Kante der Baugruppe angeordnet ist, mit dem ersten Befestigungsmittel, welches an dem Baugruppenträger angeordnet ist, verbunden. Die Baugruppe lässt sich dann beispielsweise über ein Schwenkgelenk auf bzw. in den Baugruppenträger einschwenken. Über den, an der dritten Seite des Gehäuses angeordneten Verriegelungshebel, wobei beispielsweise die erste Seite eine Oberseite der Baugruppe darstellt und die dritte Seite eine Unterseite der Baugruppe darstellt, lässt sich die Baugruppe mit dem Baugruppenträger sicher verriegeln. Dazu ist der Verriegelungshebel in seinem Drehpunkt an der Baugruppe drehbar gelagert angeordnet. Der Verriegelungshebel weist dabei einen Lastarm und einen Kraftarm auf. Der Kraftarm befindet sich beispielsweise linksseitig des Drehpunktes und der Lastarm befindet sich beispielsweise rechtsseitig des Drehpunktes. Über den Kraftarm kann nun eine Kraft auf den Lastarm übertragen werden, wobei der Lastarm das zweite Haltemittel aufweist, wobei das Haltemittel derart ausgestaltet ist, dass es nach einer Bewegung des zweiten Endes in Richtung der Unterseite des Gehäuses mit dem zweiten Befestigungsmittel des Baugruppenträgers in Eingriff steht. Je größer dabei der Weg ist, der bei einer Bewegung durch den Lastarm zurückgelegt wird, desto stärker wird der Eingriff des zweiten Haltemittels mit dem zweiten Befestigungsmittel des Baugruppenträgers und dadurch wird die Baugruppe sicher mit dem Baugruppenträger verriegelt.

In einer vorteilhaften Ausgestaltung weist das zweite Haltemittel einen Zapfen auf, welcher geeignet ist, in eine Kulissenführung einzudringen. Dabei wirkt der Zapfen mit der Kulissenführung des Baugruppenträgers derart zusammen, dass durch die Drehbewegung um den Drehpunkt der Zapfen entlang einer ansteigenden Kulissenbahn geführt wird, wodurch sich eine zunehmende Anpresskraft der Baugruppe an dem Baugruppenträger einstellt.

In einer weiter optimierten Ausgestaltung weist der Verriegelungshebel einen an einem Mittelteil angeordneten ersten Schenkel und einen zweiten Schenkel auf. Diese Schenkel tragen nun jeweils wieder einen Zapfen, wobei die Schenkel linksseitig der Baugruppe und rechtseitig der Baugruppe an jeweils einem zugehörigen Drehpunkt angeordnet sind. Durch die Ausführung des Verriegelungshebels als ein zweischenkliger Hebel mit zwei Zapfen wird eine Verriegelung weiter verbessert.

Weiterhin ist es vorteilhaft, wenn der erste Schenkel von dem ersten Ende aus zu einem zweiten Ende des Verriegelungshebels verjüngend ausgestaltet ist.

Gemäß einer weiteren Ausgestaltung ist der Verriegelungshebel schalenartig zum zumindest teilweisen Umschließen des Gehäuses ausgestaltet. Wird der Verriegelungshebel von einem entriegelnden Zustand in einen verriegelten Zustand bewegt, so kann er in einer Endposition im verriegelten Zustand, vorzugsweise drei Seiten der Baugruppe, zumindest teilweise umschließen. Der schalenförmige Hebel kann sich an Teile des Gehäuses anschmiegen und findet somit eine sichere Endposition.

In einer weiteren vorteilhaften Ausgestaltung ist am Mittelteil ein Verrastmittel angeordnet zur Verrastung mit einer im Gehäuse angeordneten Ausnehmung. Das Verrastmittel rastet vorzugsweise in der Endposition des Verriegelungshebels in die Ausnehmung des Gehäuses ein und erhöht somit eine Haltekraft des Verriegelungshebels in seiner Endposition zu der Unterseite der Baugruppe. Das Verrastmittel verhindert eine, beispielsweise durch Vibrationen, bedingte Ablösung des Verriegelungshebels aus der Endposition von der Unterseite der Baugruppe.

In einer weiterführenden Ausgestaltung dazu ist das Schaltelement dazu ausgestaltet eine Stromversorgung ab- bzw. zuzuschalten. Besteht eine Forderung, dass bei einer Automatisierungsanlage während des Wechsels einer Baugruppe aus einem Baugruppenträger die Steuerungsanlage nicht spannungslos geschaltet werden darf, da beispielsweise andere Bereiche der Steuerungsanlage z.B. aus sicherheitstechnischen Gründen weiter funktionieren müssen, so ist es häufig nötig, das stromführende Kontakte der Baugruppe unter Spannung getrennt werden müssen. Diese Trennung unter Spannung zieht möglicherweise eine Funkenbildung nach sich, durch welches die Kontakte beschädigt werden können. Außerdem ist ein abruptes Trennen der Baugruppe vom Stromkreis des Baugruppenträgers aufgrund der in der Baugruppe verbauten mikroelektronischen Schaltungen für diese schädlich. Um das abrupte Trennen bzw. die Funkenbildung zu verhindern, ist die Verriegelung der Baugruppe zum Baugruppenträger so auszulegen, dass beim Betätigen des Verriegelungshebels eine innere Abschaltung der Baugruppe erfolgt. Hierbei sollte gleichzeitig gewährleistet sein, dass die Zeit zwischen der inneren Abschaltung der Baugruppe und dem Trennen der stromführenden Kontakte ausreicht, um Energien, welche eventuell in Kapazitäten und/oder Induktivitäten gespeichert sind, abzubauen. Beim Stecken der Baugruppe in den Baugruppenträger sollte dieser Mechanismus umgekehrt funktionieren. Das interne Zuschalten der Baugruppe darf erst nach dem kompletten Steckvorgang mit einer erfolgten Kontaktierung aller Kontakte eines auf der Baugruppe angeordneten Bussteckverbinders möglich sein. Der Verriegelungshebel hat dabei die Aufgabe, die Baugruppe, welche im oberen Bereich des Baugruppenträgers eingehängt ist und nachfolgend nach unten eingeschwenkt wird, über ein Kulissensystem des Baugruppenträgers den Bussteckverbinder, einem Gegenstück des Baugruppenträgers zuzuführen und anschließend die Baugruppe sicher auf dem Baugruppenträger zu verriegeln.

Durch Ausgestaltung des Schaltmittels als eine Steckerbrücke, kann diese Steckerbrücke kurz vor erreichen der Endposition des Verriegelungshebels in ein Kontaktpaar eindringen und dadurch die Stromversorgung der Baugruppe zuschalten.

Zu der Baugruppe wird die eingangs genannte Aufgabe durch einen Baugruppenträger zum Aufnehmen der Baugruppe nach einem der Ansprüche 1 bis 9, mit einem ersten Befestigungsmittel und einem zweiten Befestigungsmittel dadurch gelöst, dass das zweite Befestigungsmittel zur Aufnahme eines Zapfens als eine Kulissenführung mit einer ansteigenden Kulissenbahn ausgestaltet ist.

Im Folgenden wird die Erfindung anhand der in den Figuren dargestellten Ausführungsbeispiele näher beschrieben und erläutert. Es zeigen:
- FIG 1: ein kastenförmiges Gehäuse nach dem Stand der Tech- nik dargestellt,
- FIG 2: zeigt eine Baugruppe und einen Baugruppenträger und
- FIG 3: zeigt in einer Detailansicht ein Schaltmittel in einem Verriegelungshebel und ein Schaltelement in- nerhalb des Gehäuses.

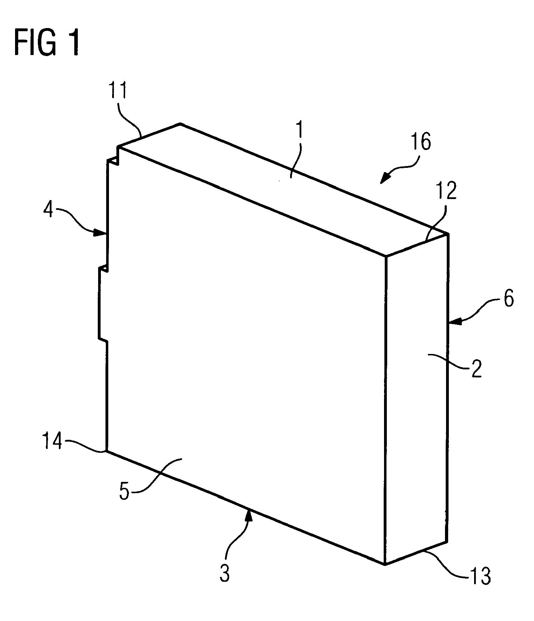

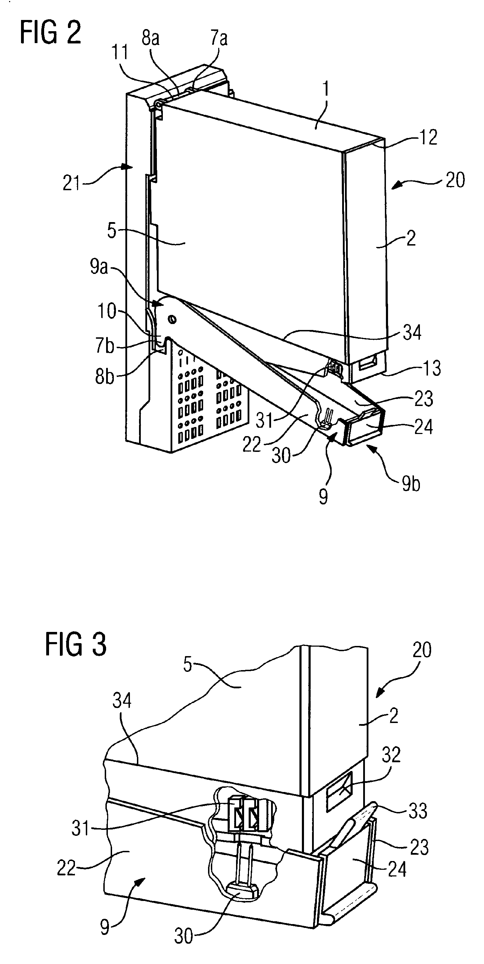

Zur Verdeutlichung der Bezugspunkte eines Gehäuses 16 ist in FIG 1 ein kastenförmiges Gehäuse 16 nach dem Stand der Technik dargestellt. Das Gehäuse 16 ist als ein rechteckförmiger Kasten ausgestaltet und weist dementsprechend eine erste Seite 1 bis eine sechste Seite 6 auf. Die fünfte Seite 5 und die sechste Seite 6 stellen dabei die Seitenflächen des Gehäuses 16 mit dem größten Flächeninhalt dar. In den Eckbereichen des Gehäuses 16 ist das Gehäuse 16 mit einer ersten Kante 11, einer zweiten Kante 12, einer dritten Kante 13 und einer vierten Kante 14 ausgestaltet. Die perspektivische Darstellung des Gehäuses 16 zeigt bereits eine Einbaulage in einen Baugruppenträger 21 (siehe FIG 2). Dabei stellt die erste Seite 1 eine Oberseite des Gehäuses 16 dar und die dritte Seite 3 eine Unterseite des Gehäuses 16 dar. Dementsprechend wird die zweite Seite 2 des Gehäuses 16 als Vorderseite und die vierte Seite 4 des Gehäuses 16 als Rückseite angesehen.

Gemäß FIG 2 ist eine Baugruppe 20 zum Einschwenken in einen Baugruppenträger 21 dargestellt. Die Baugruppe 20 weist die in FIG 1 prinzipiell beschriebene rechteckförmige Kastenform auf. An der ersten Kante 11 des Gehäuses 16 ist ein erstes Haltemittel 7a angeordnet. Als Gegenstück zu dem ersten Haltemittel 7a ist am Baugruppenträger 21 im Bereich der ersten Kante 11 ein erstes Befestigungsmittel 8a angeordnet. Das erste Haltemittel 7a und das erste Befestigungsmittel 8a bilden zusammen ein Schwenkgelenk. Mittels dieses Schwenkgelenkes kann die Baugruppe 20, welche nun im oberen Bereich des Baugruppenträgers eingehängt und mit ihm verbunden ist, in Richtung des Baugruppenträgers 21 hingeschwenkt werden. An der Unterseite des Gehäuses 16 ist im Bereich der vierten Kante 14 des Gehäuses 16 ein Verriegelungshebel 9 angeordnet. An einem ersten Ende 9a des Verriegelungshebels 9 ist ein zweites Haltemittel 7b angeordnet, welches zum Eingriff in ein zweites Befestigungsmittel 8b des Baugruppenträgers 21 ausgestaltet ist. Über eine Drehbewegung des Verriegelungshebels 9 um einen Drehpunkt wird ein zweites Ende 9b des Verriegelungshebels 9 in Richtung der Baugruppe 20 bewegt. Durch diese Bewegung kann ein Zapfen 10 des zweiten Haltemittels 7b in das zweite Befestigungsmittel 8b, welches am Baugruppenträger 21 angeordnet ist, in dieses Eindringen. Das zweite Befestigungsmittel 8b ist dabei als eine Kulissenführung ausgestaltet. Durch die Bewegung des Verriegelungshebels 9 in Richtung der Unterseite des Gehäuses 16 kann der Zapfen 10 über eine rampenförmige Ausgestaltung der Kulissenführung gleiten und somit die Baugruppe 20 zunehmend mit ihrer Rückseite in Richtung des Baugruppenträgers 21 bewegen.

Der Verriegelungshebel 9 weist einen ersten Schenkel 22 und einen zweiten Schenkel 23 auf, welche über ein Mittelteil 24 miteinander verbunden sind. Das Mittelteil 24 ist an dem zweiten Ende 9b des Verriegelungshebels 9 angeordnet. Ausgehend von dem Drehpunkt am Gehäuse 16 sind die beiden Schenkel 22,23 des Verriegelungshebels 9 in Richtung des Mittelteils 24 verjüngend ausgestaltet. Der Verriegelungshebel 9 ist als ein schalenartiger Griff ausgestaltet. Dieser Griff lässt sich über den Drehpunkt in Richtung des Gehäuses 16 bewegen und die Schenkel 22,23 sowie das Mittelteil 24 umschließen dabei die Unterseite des Gehäuses 16. In einer Endposition des Verriegelungshebels 9 kann ein am Mittelteil 24 angeordnetes Verrastmittel in einer Ausnehmung 32, welche an der Vorderseite 2 des Gehäuses 16 angeordnet ist, einrasten. Das Gehäuse 16 weist an seiner Rückseite 4 einen Stecker auf, welcher dazu ausgestaltet ist in ein Gegenstück des Baugruppenträgers 21 einzudringen und somit notwendige elektrische Verbindungen zwischen Baugruppenträger 21 und Baugruppe 20 aufzubauen. Hierbei ist es von Vorteil, dass durch den Verriegelungshebel 9 Steck- und Zugkräfte die im Stecker auftreten, über die Hebelwirkung des Verriegelungshebels 9 für einen Monteur spürbar verringert werden. Der Bewegungsablauf der Baugruppe 20 beim Einschwenken in den Baugruppenträger 21 kann folgendermaßen zusammengefasst werden. Ausgehend von der Verbindung der Baugruppe 20 über das Schwenkgelenk im oberen Teil des Baugruppenträgers 21 wird die Baugruppe 20 mit ihrer Rückseite 4 gegen den Baugruppenträger 21 geschwenkt. In Annäherung der Rückseite 4 an den Baugruppenträger 21 trifft der Zapfen 10 des geöffneten Verriegelungshebels 9 schließlich an eine am Baugruppenträger 21 angeordnete Führungskante ein und kontaktiert diese. Die Führungskante geht in eine Kulissenführung über. Diese Kulissenführung weist einen Anstieg auf an der der Zapfen 10 bei einer Schließbewegung des Verriegelungshebels 9 entlanggleiten kann und durch die ansteigende Form der Kulissenführung die Baugruppe 20 mit ihrer Rückseite zunehmend zu dem Baugruppenträger 21 gepresst wird. Mit Ende der Schließbewegung hat der Verriegelungshebel 9 eine Endposition erreicht, ein Verrastmittel ist in die Ausnehmung 32 eingerastet und Kanten der ersten und zweiten Schenkel 22,23 liegen an einer Anschmiegkante 34 des Gehäuses 16 an, letztendlich ist die Baugruppe 20 mit dem Baugruppenträger 21 fest verriegelt.

Über ein im vorderen Bereich bzw. im Bereich des zweiten Endes 9b des Verriegelungshebels 9 angeordnetes Schaltmittel 30 ist die Möglichkeit gegeben, die Baugruppe 20 beim Einschwenken sehr spät zuzuschalten bzw. beim Entriegeln der Baugruppe 20 diese sehr früh abzuschalten. Durch diesen frühen Zeitpunkt des Trennens beim Entriegeln der Baugruppe 20 wird über Kontakte eines Schaltelementes 31 gewährleistet, dass die Zeit zwischen einer internen Abschaltung der Baugruppe 20 und dem Trennen der stromführende Kontakte im Bussteckverbinder ausreicht, um frühzeitig einen Hauptstromkreis zu trennen und noch in Kapazitäten und/oder Induktivitäten gespeicherten Energien sicher abzubauen. Damit ist die Baugruppe 20 bei einem Steck- als auch bei einem Ziehvorgang frühzeitig spannungslos.

FIG 3 zeigt einen aus FIG 2 herausgenommenen detaillierten Ausschnitt für das im Bereich des zweiten Endes 9b des Verriegelungshebels 9 angeordneten Schaltmittel 30, sowie das im Gehäuse 16 der Baugruppe 20 angeordnete Schaltelement 31. Das Schaltmittel 30 ist als eine Steckerbrücke ausgestaltet und kann beim vollständigen Schließen des Verriegelungshebels 9 Kontakte des Schaltelementes 31 verbinden. Zur sicheren Einrastung des Verriegelungshebels 9 ist am Mittelteil 24 ein Verrastmittel angeordnet, welches in einer Ausnehmung 32 des Gehäuses 16 in der Endposition einrasten kann. Über einen Clip 33, welcher am Mittelteil 24 angeordnet ist, kann diese Verrastung gelöst werden und der Verriegelungshebel 9 in eine Öffnungsrichtung bewegt werden.

Durch eine derartige Ausgestaltung ist ein Baugruppen-Verriegelungssystem entstanden. Dieses ermöglicht ein sicheres Befestigen der Baugruppe 20 und gleichzeitig eine Freischaltung der Baugruppe 20 zu einem frühest möglichen Zeitpunkt während einer Entriegelungsphase. Als Vorteile sind zu nennen, ein genügender Zeitversatz zwischen dem Öffnen einer Steckerbrücke und der Dekontaktierung eines Hauptstromkreises, ein einfacher Betätigungsvorgang, eine kraftvolle Baugruppenverriegelung über eine Kulisse, eine rüttelsichere Baugruppenbefestigung und rüttelsichere Kontaktierung, eine Minimierung von Fehlbedienungen sowie konstruktionsmäßig bedingt weniger Bauteile für einen Verriegelungsmechanismus. Die im Stand der Technik genannten Schraubbolzen können somit entfallen und zudem wird ein aufwendiges Zuschrauben der Schraubbolzen bei einer Verriegelung der Baugruppe nicht mehr notwendig sein, der Monteur hat somit einen Zeitvorteil.

## Patentansprüche

1. Baugruppe (20) zum Einschwenken in einen Baugruppenträger (21), umfassend ein kastenförmiges Gehäuse (16) an dem ein erstes Haltemittel (7a) zur Verbindung mit einem ersten Befestigungsmittel (8a) des Baugruppenträgers (21) angeordnet ist, wobei durch diese Verbindung das Gehäuse (16) schwenkbar ist, dass an dem Gehäuse (16) weiterhin ein drehbar gelagerter Verriegelungshebel (9) angeordnet ist, wobei an einem ersten Ende (9a) des Verriegelungshebels (9) ein zweites Haltemittel (7b) angeordnet ist und zum Eingriff des zweiten Haltemittels (7b) in ein zweites Befestigungsmittel (8b) des Baugruppenträgers (21), der Verriegelungshebel (9) mit einem zweiten Ende (9b) in Richtung des Gehäuses (16) bewegbar ist, **dadurch gekennzeichnet , dass** im Bereich des zweiten Endes (9b) ein Schaltmittel (30) am Verriegelungshebel (9) angeordnet ist, wobei über das Schaltmittel (30) ein im Gehäuse (16) angeordnetes Schaltelement (31) betätigbar ist.

2. Baugruppe (20) nach Anspruch 1, wobei das zweite Haltemittel (7b) einen Zapfen (10) aufweist, welcher geeignet ist in eine Kulissenführung einzudringen.

3. Baugruppe (20) nach Anspruch 1 oder 2, wobei der Verriegelungshebel (9) einen an einem Mittelteil (24) angeordneten ersten Schenkel (22) und zweiten Schenkel (23) aufweist.

4. Baugruppe (20) nach Anspruch 3, wobei der erste Schenkel (22) von dem ersten Ende (9a) zu dem zweiten Ende (9b) des Verriegelungshebels (9) verjüngend ausgestaltet ist.

5. Baugruppe (20) nach einem der Ansprüche 1 bis 4, wobei der Verriegelungshebel (9) schalenartig zum zumindest teilweisen Umschließen des Gehäuses (16) ausgestaltet ist.

6. Baugruppe (20) nach einem der Ansprüche 3 bis 5, wobei am Mittelteil (24) ein Verrastmittel angeordnet ist zur Verrastung mit einer im Gehäuse (16) angeordneten Ausnehmung (32).

7. Baugruppe (20) nach einem der Ansprüche 1 bis 6, wobei das Schaltelement (31) dazu ausgestaltet ist eine Stromversorgung ab- bzw. zuzuschalten.

8. Baugruppe (20) nach einem der Ansprüche 1 bis 7, wobei am Gehäuse (16) ein Stecker angeordnet ist, welcher über die Schwenkbewegung in ein Gegenstück des Baugruppenträgers (21) einsteckbar ist.

9. Baugruppe (20) nach einem der Ansprüche 1 bis 8, wobei das Schaltmittel (30) als eine Steckerbrücke ausgestaltet ist.

10. Baugruppenträger (21) zum Aufnehmen einer Baugruppe (20) nach einem der Ansprüche 1 bis 9, mit einem ersten Befestigungsmittel (8a) und einem zweiten Befestigungsmittel (8b), **dadurch gekennzeichnet, dass** das zweite Befestigungsmittel (8b) zur Aufnahme eines Zapfens (10) als eine Kulissenführung mit einer ansteigenden Kulissenbahn ausgestaltet ist.

## Claims

1. Assembly (20) for pivoting into a mounting rack (21), comprising a housing (16) in the form of a box on which a first holding means (7a) is arranged for connection to a first attachment means (8a) of the mounting rack (21), wherein the housing (16) can be pivoted by means of this connection, in that a locking lever (9) which is mounted such that it can rotate is also arranged on the housing (16), wherein a second holding means (7b) is arranged at a first end (9a) of the locking lever (9) and a second end (9b) of the locking lever (9) can be moved in the direction of the housing (16) for the second holding means (7b) to engage in a second attachment means (8b) of the mounting rack (21), **characterized in that** a switching means (30) is arranged on the locking lever (9) in the area of the second end (9b), wherein a switching element (31) which is arranged in the housing (16) can be operated via the switching means (30).

2. Assembly (20) according to Claim 1, wherein the second holding means (7b) has a pin (10) which is suitable for entering a slotted-link guide.

3. Assembly (20) according to Claim 1 or 2, wherein the locking lever (9) has a first limb (22) and a second limb (23) which are arranged on a center part (24).

4. Assembly (20) according to Claim 3, wherein the first limb (22) tapers from the first end (9a) to the second end (9b) of the locking lever (9).

5. Assembly (20) according to one of Claims 1 to 4, wherein the locking lever (9) is in the form of a shell in order to at least partially surround the housing (16).

6. Assembly (20) according to one of Claims 3 to 5, wherein a latching means is arranged on the center part (24) for latching with a recess (32) which is arranged in the housing (16).

7. Assembly (20) according to one of Claims 1 to 6, wherein the switching element (31) is designed to switch a power supply off and on.

8. Assembly (20) according to one of Claims 1 to 7, wherein a plug is arranged on the housing (16) and can be plugged into a mating piece of the mounting rack (21) by the pivoting movement.

9. Assembly (20) according to one of Claims 1 to 8, wherein the switching means (30) is in the form of a plug link.

10. Mounting rack (21) for holding an assembly (20) according to one of Claims 1 to 9, having a first attachment means (8a) and a second attachment means (8b), **characterized in that** the second attachment means (8b) is designed as a slotted-link guide having a rising slotted-link path in order to hold a pin (10).

## Revendications

1. Module ( 20 ) à basculer dans un porte-module ( 21 ), comprenant un boîtier ( 16 ) en forme de caisson sur lequel est disposé un premier moyen ( 7a ) de maintien pour la liaison avec un premier moyen ( 8a ) de fixation du porte-module ( 21 ), dans lequel par cette liaison le boîtier ( 16 ) peut pivoter, en ce que sur le boîtier ( 16 ) est disposé en outre un levier ( 9 ) de verrouillage monté tournant, dans lequel sur une première extrémité ( 9a ) du levier ( 9 ) de verrouillage est monté un deuxième moyen ( 7b ) de maintien et, pour la pénétration du deuxième moyen ( 7b ) de maintien dans un deuxième moyen ( 8b ) de fixation du porte-module ( 21 ), le levier ( 9 ) de verrouillage peut être déplacé par une deuxième extrémité ( 9b ) en direction du boîtier ( 16 ), **caractérisé en ce que** dans la zone de la deuxième extrémité ( 9b ) un moyen ( 30 ) de commutation est monté sur le levier ( 9 ) de verrouillage, un élément ( 31 ) de commutation disposé dans le boîtier ( 21 ) pouvant être actionné par le moyen ( 30 ) de commutation.

2. Module suivant la revendication 1, dans lequel le deuxième moyen ( 7b ) de maintien comporte un tenon ( 10 ) propre à pénétrer dans un guidage à coulisse.

3. Module suivant la revendication 1 ou 2, dans lequel le levier ( 9 ) de verrouillage a une première branche ( 22 ) disposée sur une partie ( 24 ) médiane et une deuxième branche ( 23 ) .

4. Module suivant la revendication 3, dans lequel la première branche ( 22 ) se rétrécit de la première extrémité ( 9a ) à la deuxième extrémité ( 9b ) du levier ( 9 ) de verrouillage.

5. Module suivant l'une des revendications 1 à 4, dans lequel le levier ( 9 ) de verrouillage est conformé en coque pour entourer au moins en partie le boîtier ( 16 ).

6. Module suivant l'une des revendications 3 à 5, dans lequel sur la partie ( 24 ) médiane est disposé un moyen d'encliquetage pour l'encliquetage avec un évidement ( 32 ) ménagé dans le boîtier ( 16 ).

7. Module suivant l'une des revendications 1 à 6, dans lequel l'élément ( 31 ) de commutation est conformé pour mettre hors circuit ou en circuit une alimentation en courant.

8. Module suivant l'une des revendications 1 à 7, dans lequel sur le boîtier est disposé un connecteur qui peut être enfiché par le mouvement de basculement dans une pièce antagoniste du porte-module ( 21 ).

9. Module suivant l'une des revendications 1 à 8, dans lequel le moyen ( 30 ) de commutation est conformé en pont formant connecteur.

10. Porte-module ( 21 ) de réception d'un module ( 20 ) suivant l'une des revendications 1 à 9 comprenant un premier moyen ( 8a ) de fixation et un deuxième moyen ( 8b ) de fixation, **caractérisé en ce que** le deuxième moyen ( 8b ) de fixation est, pour la réception d'un tenon ( 10 ), conformé en guidage à coulisse ayant une piste de coulisse montante.
